# EUROPEAN PATENT APPLICATION

(11) **EP 4 456 326 A1**
(43) Date of publication of application: **30.10.2024**
(21) Application number: 22910813.9
(22) Date of filing: 01.12.2022
(51) Int. Cl.: H01Q 15/08

(54) **COMPOSITE MEMBER**

(30) Priority: 22.12.2021 JP 2021208048
(71) Applicant: Panasonic Intellectual Property Management Co., Ltd., Osaka-shi, Osaka 540-6207 (JP)
(72) Inventor: KURIZOE, Naoki, Kadoma-shi, Osaka 571-0057 (JP); HAYASHI, Yuta, Kadoma-shi, Osaka 571-0057 (JP); YOSHIOKA, Tatsuro, Kadoma-shi, Osaka 571-0057 (JP); SATO, Natsuki, Kadoma-shi, Osaka 571-0057 (JP); SAWA, Ryosuke, Kadoma-shi, Osaka 571-0057 (JP)
(74) Representative: Müller-Boré & Partner Patentanwälte PartG mbB
(86) International application number: PCT/JP2022/044414
(87) International publication number: WO 2023/120096

(57) **Abstract**

Provided is a composite member (1) including a matrix part (10) that includes inorganic substance particles (11) and is formed by bonding the inorganic substance particles (11) to each other, organic substance particles (20) present in a dispersed state inside the matrix part (10), and a radio wave absorbing material (30) present in a dispersed state inside the matrix part (10), wherein the matrix part (10) includes at least one of a metal oxide or a metal oxide hydroxide.

## Description

### TECHNICAL FIELD

The present invention relates to a composite member.

### BACKGROUND ART

A dielectric lens which refracts a radio wave emitted from an antenna and adjusts the traveling direction of the radio wave has been known. Patent Literature 1 discloses a dielectric lens formed of plastic to which an appropriate amount of a ferroelectric powder is added. Patent Literature 1 discloses that the dielectric lens can be designed to be lighter and stronger than a dielectric lens formed of ceramic alone and to have a higher relative permittivity than that of a dielectric lens formed of a plastic alone or a fiber-reinforced plastic alone.

### CITATION LIST

### PATENT LITERATURE

Patent Literature 1: Japanese Unexamined Patent Application Publication No. 2000-101336

### SUMMARY OF THE INVENTION

However, compared with inorganic substances such as ceramic, resin may deteriorate due to moisture in the atmosphere. Thus, a dielectric lens using a resin matrix may not have sufficient durability. In addition, since resin easily transmits radio waves, conventional dielectric lenses alone may not be able to control the radio wave strength.

The present invention has been made in consideration of the above issues, which are inherent in the related art. An object of the present invention is to provide a composite member that has excellent durability compared with the case using a resin matrix and is capable of controlling radio wave properties.

In response to the above issue, a composite member according to an aspect of the present invention includes a matrix part that includes inorganic substance particles and is formed by bonding the inorganic substance particles to each other. The composite member includes organic substance particles present in a dispersed state inside the matrix part, and a radio wave absorbing material present in a dispersed state inside the matrix part. The matrix part includes at least one of a metal oxide or a metal oxide hydroxide.

### BRIEF DESCRIPTION OF DRAWINGS

[Fig. 1] Fig. 1 is a plan view illustrating an example of a composite member according to the present embodiment.
[Fig. 2] Fig. 2 is a cross-sectional view illustrating an example of a transmission part according to the present embodiment.
[Fig. 3] Fig. 3 is a cross-sectional view illustrating an example of a shield part according to the present embodiment.
[Fig. 4] Fig. 4 is a cross-sectional view illustrating an example of a sensor according to the present embodiment.
[Fig. 5] Fig. 5 is a diagram illustrating a sensor used in a simulation.
[Fig. 6] Fig. 6 is a diagram illustrating a radiation pattern when a sensor is covered with ABS.
[Fig. 7] Fig. 7 is a diagram illustrating a radiation pattern when a sensor is covered with glass.
[Fig. 8] Fig. 8 is a diagram illustrating a radiation pattern when a sensor is covered with aluminum oxide.
[Fig. 9] Fig. 9 is a graph illustrating a relationship between the relative permittivity and the radiation angle.
[Fig. 10] Fig. 10 is a diagram illustrating a radiation pattern in the XZ plane measured for sample 1.
[Fig. 11] Fig. 11 is a diagram illustrating a radiation pattern in the YZ plane measured for sample 1.
[Fig. 12] Fig. 12 is a diagram illustrating a radiation pattern in the XZ plane measured for sample 2.
[Fig. 13] Fig. 13 is a diagram illustrating a radiation pattern in the YZ plane measured for sample 2.
[Fig. 14] Fig. 14 illustrates a configuration when a sensor is not covered with a shield plate.
[Fig. 15] Fig. 15 illustrates a configuration when a half of the sensor is covered with a shield plate.
[Fig. 16] Fig. 16 illustrates a radiation pattern when a sensor is not covered with a shield plate.
[Fig. 17] Fig. 17 illustrates a radiation pattern when a half of the sensor is covered with a shield plate.
[Fig. 18] Fig. 18 is a photograph illustrating an example of a composite member including a shield part and a transmission part.
[Fig. 19] Fig. 19 is a diagram illustrating a backscattered electron image of sample 5.
[Fig. 20] Fig. 20 is a diagram illustrating a backscattered electron image of sample 6.
[Fig. 21] Fig. 21 illustrates an image obtained by binarizing the backscattered electron image of sample 5.
[Fig. 22] Fig. 22 illustrates an image obtained by binarizing the backscattered electron image of sample 6.

### DESCRIPTION OF EMBODIMENTS

Referring to the drawings, a detailed description is given below of a composite member, a radio wave sensor, and a method for producing the composite member according to the present embodiment. Note that dimensional ratios in the drawings are exaggerated for convenience of the description and are sometimes different from actual ratios.

### [Composite member]

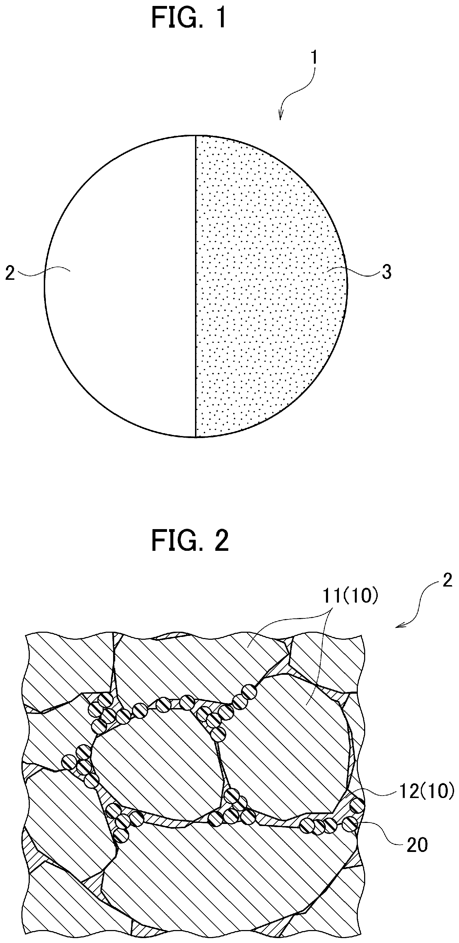

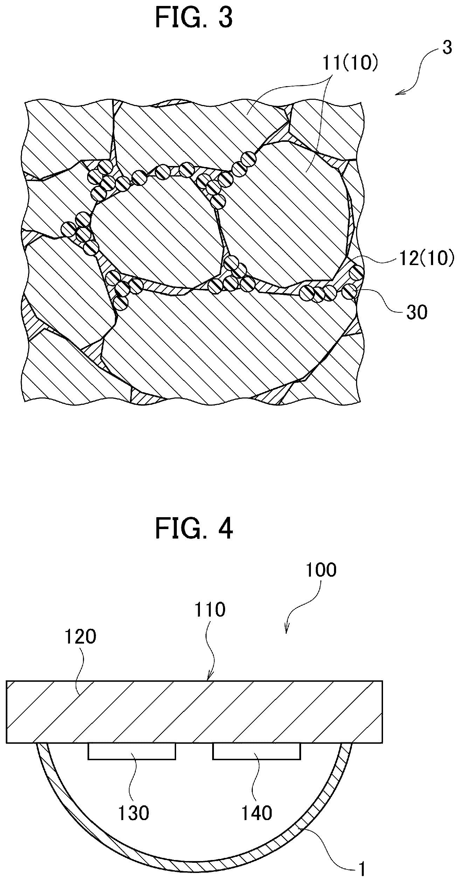

As illustrated in Fig. 1, a composite member 1 according to the present embodiment includes a transmission part 2 and a shield part 3. As illustrated in Fig. 2, the transmission part 2 includes a matrix part 10 and organic substance particles 20. As illustrated in Fig. 3, the shield part 3 includes the matrix part 10 and a radio wave absorbing material 30. That is, the composite member 1 according to the present embodiment includes the matrix part 10, the organic substance particles 20, and the radio wave absorbing material 30.

The matrix part 10 of the transmission part 2 and the matrix part 10 of the shield part 3 are chemically bonded. It is thus possible to provide the composite member 1 having high mechanical strength as a whole. In the present embodiment, the transmission part 2 does not include the radio wave absorbing material 30, and the shield part 3 does not include the organic substance particles 20. That is, the volume fraction of the organic substance particles 20 in the transmission part 2 is larger than that of the organic substance particles 20 in the shield part 3. The volume fraction of the radio wave absorbing material 30 in the transmission part 2 is smaller than that of the radio wave absorbing material 30 in the shield part 3. However, the transmission part 2 may include the radio wave absorbing material 30, and the shield part 3 may include the organic substance particles 20.

The matrix part 10 includes multiple inorganic substance particles 11 and is formed by bonding the multiple inorganic substance particles 11 to each other. The matrix part 10 may also include a bonding part 12 for bonding each of the multiple inorganic substance particles 11. Since adjacent inorganic substance particles 11 are bonded via the bonding part 12, the inorganic substance particles 11 are three-dimensionally bonded to each other, and thus the composite member 1 having high mechanical strength can be obtained. Multiple inorganic substance particles 11 may have a part where inorganic substance particles 11 are bonded directly without using the bonding part 12. The inorganic substance particles 11 may be in point contact, or may be in surface contact where surfaces of inorganic substance particles 11 are in contact with each other.

The bonding part 12 may be present between adjacent inorganic substance particles 11. The bonding part 12 may be in direct contact with the inorganic substance particles 11. The bonding part 12 may cover at least part of the surface of each of the inorganic substance particles 11 and may cover the entire surface of each of the inorganic substance particles 11. The presence of the bonding part 12 ensures that the inorganic substance particles 11 and the bonding part 12 are tightly bonded to each other, and thus the composite member 1 can be obtained having excellent density and excellent mechanical strength.

The matrix part 10 includes at least one of a metal oxide or a metal oxide hydroxide. An inorganic substance containing at least one of a metal oxide or a metal oxide hydroxide may be included in at least one of the multiple inorganic substance particles 11 or the bonding part 12. That is, the above-described inorganic substance may be included in either one of the inorganic substance particles 11 or the bonding part 12, and may be included in both of the multiple inorganic substance particles 11 and the bonding part 12.

At least one of the metal oxide or the metal oxide hydroxide preferably contains at least one metallic element selected from the group consisting of an alkali metal, an alkaline earth metal, a transition metal, a base metal, and a semimetal. In this description, the alkaline earth metal includes beryllium and magnesium in addition to calcium, strontium, barium, and radium. The base metal includes aluminum, zinc, gallium, cadmium, indium, tin, mercury, thallium, lead, bismuth, and polonium. The semimetal includes boron, silicon, germanium, arsenic, antimony, and tellurium. Among these, the inorganic substance preferably contains at least one metallic element selected from the group consisting of zinc, aluminum, and magnesium. The inorganic substance containing a metallic element described above can easily form the bonding part 12 derived from the inorganic substance, using a pressure heating method as described below.

The metal oxide may include at least one selected from the group consisting of, for example, zinc oxide, magnesium oxide, and a complex of zinc oxide and magnesium oxide. With such a metal oxide, the composite member 1 can be obtained having high durability. Note that the oxide of a metallic element mentioned above may include a phosphate, a silicate, an aluminate, and a borate, in addition to a compound in which only oxygen is bonded to the metallic element. The inorganic substance included in the inorganic substance particles 11 may be a complex anionic compound including a metallic element described above. The complex anionic compound is a substance including multiple anions in a single compound, and examples include an acid fluoride, an acid chloride, and an oxynitride.

The metal oxide hydroxide may include, for example, an aluminum oxide hydroxide. An example of the aluminum oxide hydroxide is boehmite represented by a composition formula of AlOOH. Boehmite has a property of high chemical stability since it is insoluble in water and hardly reacts with acids and alkalis at room temperature. Boehmite also has a property of excellent heat resistance due to high dehydration temperature of around 500 °C. Since boehmite has a specific gravity of about 3.07, when the composite member 1 includes boehmite, the composite member 1 can be obtained being lightweight and having excellent chemical stability.

When the inorganic substance included in the matrix part 10 is boehmite, the inorganic substance particles 11 may be particles including only a boehmite phase, or particles including a mixed phase of boehmite, and aluminum oxide or aluminum hydroxide other than boehmite. For example, the inorganic substance particles 11 may be particles in which a phase including boehmite and a phase including gibbsite (Al(OH)₃) are mixed. Adjacent inorganic substance particles 11 preferably bond via at least one of an aluminum oxide or aluminum oxide hydroxide. That is, it is preferable that the inorganic substance particles 11 do not bond via an organic binder including an organic compound and do not bond via an inorganic binder including an inorganic substance other than the aluminum oxide and aluminum oxide hydroxide. Note that when adjacent inorganic substance particles 11 bond via at least one of an aluminum oxide or aluminum oxide hydroxide, the aluminum oxide and aluminum oxide hydroxide may be crystalline and may be amorphous.

When the composite member 1 includes boehmite, the percentage of presence of the boehmite phase is preferably 50% by mass or more, more preferably 60% by mass or more, and even more preferably 70% by mass or more. By increasing the percentage of the boehmite phase, the composite member 1 can be obtained being lightweight and excellent in chemical stability and heat resistance. Note that the percentage of the boehmite phase in the composite member 1 can be obtained by measuring the X-ray diffraction pattern of the composite member 1 using an X-ray diffraction method and then performing a Rietveld analysis.

When the inorganic substance included in the matrix part 10 is boehmite, the bonding part 12 may include a boehmite phase. When the bonding part 12 includes the boehmite phase, the multiple inorganic substance particles 11 may include aluminum nitride. Aluminum nitride has a property of high electrical resistance and high dielectric strength, and also exhibits very high thermal conductivity as a ceramic material. The multiple inorganic substance particles 11 may not be bonded by an organic binder including an organic compound, and may not be bonded by an inorganic binder other than a boehmite phase. As is described below, the composite member 1 can be formed by heating a mixture of an inorganic substance powder and water under pressure, and there is no need to use a reaction promoter or the like. Thus, it becomes possible for the composite member 1 to retain the original properties of aluminum nitride and boehmite because there are no impurities derived from the organic binder, the inorganic binder, and the reaction promoter.

It is more preferable that the inorganic substance included in the matrix part 10 contain at least one of an oxide or oxide hydroxide of a metallic element described above as a main component. That is, the inorganic substance preferably contains at least one of an oxide or oxide hydroxide of a metallic element described above in an amount of 50 mol% or more, more preferably in an amount of 80 mol% or more, and even more preferably in an amount of 90 mol% or more. The composite member 1 also preferably contains at least one of the oxide or oxide hydroxide as a main component.

The inorganic substance included in the matrix part 10 is preferably a polycrystalline substance. When the inorganic substance included in the matrix part 10 is a polycrystalline substance, the composite member 1 can be obtained having higher durability than when the inorganic substance is amorphous. It is more preferable that the inorganic substance particles 11 be crystalline particles containing at least one metallic element selected from the group consisting of an alkali metal, an alkaline earth metal, a transition metal, a base metal, and a semimetal. It is also preferable that the inorganic substance particles 11 be crystalline particles containing at least one of an oxide or oxide hydroxide of a metallic element described above. It is more preferable that the inorganic substance particles 11 be crystalline particles mainly including at least one of an oxide or oxide hydroxide of a metallic element described above. It is preferable that the inorganic substance particles 11 contain at least one of an oxide or oxide hydroxide of a metallic element described above in an amount of 80 mol% or more, more preferably in an amount of 90 mol% or more, and even more preferably in an amount of 95 mol% or more. Note that the inorganic substance may be single crystal and may be polycrystalline.

The inorganic substance included in the composite member 1 preferably includes no hydrate of a calcium compound. The calcium compound here is tricalcium silicate (alite, 3CaO·SiO₂), dicalcium silicate (belite, 2CaO·SiO₂), calcium aluminate (3CaO·Al₂O₃), calcium aluminoferrite (4CaO·Al₂O₃·Fe₂O₃), or calcium sulfate (CaSO₄·2H₂O). When the inorganic substance included in the composite member 1 includes a hydrate of the above-described calcium compound, the porosity in the cross section of the composite member 1 exceeds 20%, and the strength may be reduced. Thus, it is preferable that the inorganic substance include no hydrate of the above-described calcium compound. It is also preferable that the inorganic substance included in the composite member 1 do not contain phosphate cement, zinc phosphate cement, and calcium phosphate cement. As the inorganic substance does not include these cements, the porosity in the cross section of the composite member 1 is reduced, and thus the mechanical strength can be enhanced.

The average particle size of the multiple inorganic substance particles 11 is not particularly limited. The average particle size of the inorganic substance particles 11 is preferably within a range of 50 nm or more and 50 µm or less, more preferably of 300 nm or more and 30 µm or less, and even more preferably of 300 nm or more and 20 µm or less. When the average particle size of the inorganic substance particles 11 is within these ranges, the inorganic substance particles 11 firmly bond with each other, and this can increase the strength of the composite member 1. Note that in this description, the value of "average particle size" is, unless otherwise stated, a value calculated as an average value of particle size of particles observed in several to several tens of visual fields by using observation means, such as a scanning electron microscope (SEM) or a transmission electron microscope (TEM).

The shape of the inorganic substance particles 11 is not particularly limited and can be spherical, for example. The inorganic substance particles 11 may be whisker-like (acicular) particles or scaly particles. Whisker-like particles or scaly particles have higher contact with other particles compared to spherical particles, which easily improves the strength of the composite member 1. Thus, by using particles of such a shape for the inorganic substance particles 11, it becomes possible to enhance the strength of the entire composite member 1.

Here, the inorganic substance included in the composite member 1 preferably includes substantially no hydrate. In this description, "an inorganic substance includes substantially no hydrate" means that the inorganic substance does not intentionally contain any hydrate. Thus, when a hydrate is mixed into an inorganic substance as an inevitable impurity, the condition: "an inorganic substance includes substantially no hydrate" is satisfied. Note that since boehmite is a metal oxide hydroxide, boehmite is not included in hydrates in this description.

The bonding part 12 preferably includes an amorphous inorganic compound. Specifically, the bonding part 12 may be a part including only an amorphous inorganic compound and may be a part of a mixture of an amorphous inorganic compound and a crystalline inorganic compound. The bonding part 12 may be a part in which a crystalline inorganic compound is dispersed inside an amorphous inorganic compound. When amorphous and crystalline inorganic compounds are mixed, the amorphous inorganic compound and the crystalline inorganic compound may have the same chemical composition or different chemical compositions from each other.

It is preferable that the inorganic substance particles 11 and the bonding part 12 contain the same metallic element and that the metallic element be at least one selected from the group consisting of an alkali metal, an alkaline earth metal, a transition metal, a base metal, and a semimetal. That is, the inorganic substance included in the inorganic substance particles 11 and the amorphous inorganic substance included in the bonding part 12 preferably include at least the same metallic element. The inorganic substance included in the inorganic substance particles 11 and the amorphous inorganic substance included in the bonding part 12 may have the same chemical composition or different chemical composition from each other. Specifically, when the metallic element is zinc, the inorganic substance included in the inorganic substance particles 11 and the amorphous inorganic substance included in the bonding part 12 may both be zinc oxide (ZnO). Alternatively, the inorganic substance included in the inorganic substance particles 11 may be ZnO, and the amorphous inorganic substance included in the bonding part 12 may be a zinc-containing oxide other than ZnO.

The organic substance particles 20 are present in a dispersed state inside the matrix part 10. Dispersing the organic substance particles 20 inside the matrix part 10 can reduce contact of the organic substance particles 20 with oxygen and water vapor and suppress deterioration of the organic substance particles 20. The organic substance particles 20 may be arranged between adjacent inorganic substance particles 11. The organic substance particles 20 may be surrounded by the bonding part 12 or by the inorganic substance particles 11 and the bonding part 12. The shape of the organic substance particles 20 is not particularly limited, and examples include a spherical shape, a scale shape, a needle shape, a fiber shape, a plate shape, a disk shape, and an indefinite shape.

The relative permittivity of the organic substance particles 20 is different from the relative permittivity of the matrix part 10. That is, the relative permittivity of the organic substance particles 20 may be larger than that of the matrix part 10. The relative permittivity of the organic substance particles 20 may be smaller than that of the matrix part 10. Since the relative permittivity of the matrix part 10 is different from that of the organic substance particles 20, the relative permittivity of the composite member 1 can be changed compared with a member made from the matrix part 10 without the organic substance particles 20. By changing the relative permittivity, it becomes possible to change the radiation angle of a radio wave transmitted through the composite member 1. Thus, the radiation angle of the radio wave transmitted through the composite member 1 can be adjusted by adjusting the type, the added amount, or the like of the organic substance particles 20.

The organic substance particles 20 may include at least one of cellulose particles or resin particles. Since the relative permittivities of these materials are often significantly different compared with those of inorganic substances, the relative permittivity of the composite member 1 can be effectively changed. The resin particles may include at least one type of resin selected from the group consisting of a fluororesin, ABS, an acrylic resin, polyethylene terephthalate, polypropylene, and polycarbonate. For example, since the relative permittivity of the fluororesin is small, even when a small amount of fluororesin is added, the relative permittivity of the composite member 1 can be made smaller than that of the matrix part 10 alone. The fluororesin may include at least one selected from the group consisting of, for example, polytetrafluoroethylene (PTFE), polychlorotrifluoroethylene (PCTFE), polyvinylidene fluoride (PVDF), polyvinyl fluoride (PVF), perfluoroalkoxy fluoropolymer (PFA), tetrafluoroethylene-hexafluoropropylene copolymer (FEP), ethylene-tetrafluoroethylene copolymer (ETFE), and ethylene-chlorotrifluoroethylene copolymer (ECTFE).

The thermal conductivity of the matrix part 10 may be higher than that of the organic substance particles 20. Thus, since heat is easily dissipated through the matrix part 10, the heat dissipation of the composite member 1 can be enhanced. Hence, even when the composite member 1 is continuously irradiated with a radio wave, the temperature rise of the composite member 1 can be suppressed. Consequently, the radiation property of the composite member 1 can be stabilized. The thermal conductivity of the matrix part 10 may exceed 1 W/m·K. The thermal conductivity of the matrix part 10 may be 5 W/m·K or more. The thermal conductivity of the matrix part 10 may be 500 W/m K or less. The thermal conductivity of the organic substance particles 20 may be 1 W/m K or less. The thermal conductivity of the organic substance particles 20 may be 0.01 W/m·K or more. The thermal conductivity of the matrix part 10 can be measured according to the provisions of JIS R1611:2010. The thermal conductivity of the organic substance particles 20 can be measured according to the provisions of JIS A1412-2:1999.

The average particle size of the organic substance particles 20 is not particularly limited. The average particle size of the organic substance particles 20 may be within a range of 50 nm or more and 50 µm or less. When the average particle size of the organic substance particles 20 is within this range, the bonding between the inorganic substance particles 11 is strengthened, and thus the strength of the composite member 1 can be enhanced. The average particle size of the organic substance particles 20 may be 500 nm or more, or 1 µm or more. The average particle size of the organic substance particles 20 may be 30 µm or less, or 10 µm or less.

The radio wave absorbing material 30 is present in a dispersed state inside the matrix part 10. By dispersing the radio wave absorbing material 30 inside the matrix part 10, the bonding between the inorganic substance particles 11 is strengthened, and thus the strength of the composite member 1 can be improved. The radio wave absorbing material 30 may be arranged between adjacent inorganic substance particles 11. The radio wave absorbing material 30 may be surrounded by the bonding part 12 or by the inorganic substance particles 11 and the bonding part 12. The shape of the radio wave absorbing material 30 is not particularly limited, and examples include a spherical shape, a scale shape, a needle shape, a fiber shape, a plate shape, a disk shape, and an indefinite shape.

The radio wave absorbing material 30 is a material for absorbing radio waves. By absorbing radio waves by the radio wave absorbing material 30, transmission of radio waves through the shield part 3 can be suppressed. Thus, for example, when the composite member 1 is used as a cover for a radio wave sensor, false detection outside a detection area can be suppressed by shielding radio waves using the shield part 3 and narrowing the detection area. The radio wave absorbing material 30 can absorb radio waves by converting the energy of radio waves into heat. The radio wave absorbing material 30 may be a dielectric radio wave absorbing material, a magnetic radio wave absorbing material, a conductive radio wave absorbing material, or the like.

The dielectric radio wave absorbing material absorbs radio waves due to the dielectric loss caused by a polarization reaction of molecules. The dielectric radio wave absorbing material may include a carbon-containing material in which carbon is dispersed in a dielectric such as rubber, urethane, polystyrene, or the like.

The magnetic radio wave absorbing material absorbs radio waves due to the magnetic loss of the magnetic material. The magnetic radio wave absorbing material may include at least one selected from the group consisting of iron, nickel, and ferrite.

The conductive radio wave absorbing material absorbs radio waves due to the resistance loss within the material. The conductive radio wave absorbing material may include at least one of a metal or a non-metal. The metal may include at least one selected from the group consisting of aluminum, copper, nickel, and stainless steel. The non-metal may include carbon.

The radio wave absorbing material 30 preferably includes a non-metal from the viewpoint of suppressing the reflection of radio waves. The radio wave absorbing material 30 may include carbon, for example, and may be carbon. Since carbon has low reactivity, the durability of the composite member 1 can be further improved. The carbon may include, for example, at least one selected from the group consisting of carbon black, graphite, carbon fiber, carbon nanotubes, and diamond.

In the composite member 1 according to the present embodiment, the radio wave absorbing material 30 is partially present. Specifically, the volume fraction of the radio wave absorbing material 30 in the shield part 3 is larger than that of the radio wave absorbing material 30 in the transmission part 2. Thus, the transmission part 2 is easy to transmit radio waves, and the shield part 3 is difficult to transmit radio waves. Thus, for example, when the composite member 1 is used for a radio wave sensor, the detection region of a radio wave sensor can be narrowed down to a desired range by adjusting the region of the shield part 3. The radio wave absorbing material 30 may include a non-metal and be partially present. Since the non-metal suppresses the reflection of radio waves, radio waves can be more effectively shielded. Specifically, the radio wave absorbing material 30 may include carbon and be partially present.

In the composite member 1, the volume fraction of the inorganic substance particles 11 is preferably 30% or more. In this case, the obtained composite member 1 becomes a structure that easily utilizes the properties of the inorganic substance particles 11. In the composite member 1, the volume fraction of the multiple inorganic substance particles 11 is more preferably 40% or more, and even more preferably 50% or more. The volume fraction of the inorganic substance particles 11 is preferably larger than that of the bonding part 12.

For the same reason as described above, as the volume fraction of the inorganic substance particles 11 in the transmission part 2, the same volume fraction as that in the composite member 1 described above can be adopted. That is, the volume fraction of the inorganic substance particles 11 in the transmission part 2 may be 30% or more. As the volume fraction of the inorganic substance particles 11 in the shield part 3, the same volume fraction as that of the composite member 1 described above can be adopted. That is, in the shield part 3, the volume fraction of the inorganic substance particles 11 may be 30% or more.

The volume fraction of the organic substance particles 20 in the composite member 1 may be less than 50%. In the present embodiment, the volume fraction of the organic substance particles 20 in the transmission part 2 may be less than 50%. When the volume fraction of the organic substance particles 20 is less than 50%, the mechanical properties of the composite member 1 can be improved. The volume fraction of the organic substance particles 20 may be 0.1% or more. When the volume fraction of the organic substance particles 20 is 0.1% or more, the relative permittivity of the composite member 1 can be changed more significantly than that of the matrix part 10. The volume fraction of the organic substance particles 20 may be 5% or more, 10% or more, or 20% or more. The volume fraction of the organic substance particles 20 may be less than 40%.

The volume fraction of the radio wave absorbing material 30 in the composite member 1 may be within a range of 20% or more and less than 50%. In the present embodiment, the volume fraction of the radio wave absorbing material 30 in the shield part 3 may be within a range of 20% or more and less than 50%. When the volume fraction of the radio wave absorbing material 30 is 20% or more, radio waves can be absorbed more effectively. When the volume fraction of the radio wave absorbing material 30 is less than 50%, the mechanical properties of the composite member 1 can be improved. The volume fraction of the radio wave absorbing material 30 may be 25% or more, or 30% or more. The volume ratio of the radio wave absorbing material 30 may be less than 45%, or less than 40%.

The porosity in the cross section of the composite member 1 is preferably 20% or less. That is, when the cross section of the composite member 1 is observed, the average value of the percentage of pores per unit area is preferably 20% or less. When the porosity is 20% or less, the occurrence of cracks in the composite member 1 originating from pores is suppressed, and thus it becomes possible to increase the flexural strength of the composite member 1. Note that the porosity in the cross section of the composite member 1 is preferably 15% or less, more preferably 10% or less, and even more preferably 5% or less. The smaller the porosity in the cross section of the composite member 1, the more the cracks originating from pores are suppressed, and thus it becomes possible to increase the strength of the composite member 1.

In this specification, porosity can be determined as follows. First, the cross section of the composite member 1 is observed to discriminate between pores and non-pores. Then, the unit area and the area of pores in the unit area are measured to obtain the percentage of pores per unit area, and the value is defined as the porosity. Note that it is more preferable that the percentage of pores per unit area be obtained at multiple locations for the cross section of the composite member 1 and then the average value of the percentage of pores per unit area be defined as the porosity. Note that when observing the cross section of the composite member 1, an optical microscope, a scanning electron microscope (SEM), or a transmission electron microscope (TEM) is usable. The unit area and the area of pores in the unit area may be measured by binarizing an image observed using the microscope.

The size of pores inside the composite member 1 is not particularly limited but is preferably as small as possible. As the size of pores is small, cracks originating from pores are suppressed, and thus it becomes possible to enhance the strength of the composite member 1 and to improve the machinability of the composite member 1. Note that the size of pores of the composite member 1 is preferably 5 µm or less, more preferably 1 µm or less, and even more preferably 100 nm or less. The size of pores inside the composite member 1 can be determined by observing the cross section of the composite member 1 with a microscope, in the same manner as the porosity mentioned above.

In the composite member 1, the organic substance particles 20 preferably are not present continuously from the surface to the inside of the matrix part 10. The organic substance particles 20 present on the surface of the matrix part 10 may deteriorate by coming into contact with oxygen and water vapor in the atmosphere. The organic substance particles 20 present continuously from the surface to the inside of the matrix part 10 may also deteriorate due to the oxidative deterioration of the organic substance particles 20 present on the surface of the matrix part 10. Thus, from the viewpoint of further suppressing the deterioration of the organic substance particles 20, it is preferable that the organic substance particles 20 be not present continuously from the surface to the inside of the matrix part 10. For the same reason, it is preferable that the radio wave absorbing material 30 be not present continuously from the surface to the inside of the matrix part 10. It is preferable that the organic substance particles 20 and the radio wave absorbing material 30 be not present continuously from the surface to the inside of the matrix part 10.

The thickness t of the composite member 1 is not particularly limited and can be 50 µm or more, for example. As is described below, the composite member 1 according to the present embodiment is formed using a pressure heating method. Thus, the composite member 1 can be easily obtained having a large thickness. Note that the thickness of the composite member 1 can be 1 mm or more, or 1 cm or more. The upper limit of the thickness of the composite member 1 is not particularly limited and can be 50 cm, for example.

As described above, the composite member 1 according to the present embodiment includes the matrix part 10 that includes the multiple inorganic substance particles 11 and is formed by bonding the inorganic substance particles 11 to each other. The composite member 1 includes the organic substance particles 20 present in a dispersed state inside the matrix part 10 and the radio wave absorbing material 30 present in a dispersed state inside the matrix part 10. The matrix part 10 contains at least one of a metal oxide or a metal oxide hydroxide.

Since the composite member 1 is provided with the organic substance particles 20, a relative permittivity different from that of the matrix part 10 can be given to the composite member 1. Consequently, the composite member 1 can realize a radiation angle different from that of the matrix part 10. In addition, since the organic substance particles 20 are dispersed inside the matrix part 10, they are less likely to come into direct contact with moisture and the like in the atmosphere and do not easily deteriorate. Furthermore, since the composite member 1 is provided with the radio wave absorbing material 30, the strength of radio waves transmitted through the composite member 1 can be reduced. Thus, the composite member 1 according to the present embodiment has excellent durability compared with the case where a resin matrix is used and can control radio wave properties. As described above, the composite member 1 according to the present embodiment has excellent durability and can control the radio wave properties, and thus it can be suitably used as a cover for a radio wave sensor, for example. Specifically, the composite member 1 can be suitably used as a dielectric lens.

Note that the above embodiment has described an example in which the composite member 1 includes the transmission part 2 and the shield part 3. The transmission part 2 includes the matrix part 10 and the organic substance particles 20, and the shield part 3 includes the matrix part 10 and the radio wave absorbing material 30. However, the composite member 1 according to the present embodiment is not limited to such a form. For example, the composite member 1 may include multiple parts of three or more having different volume fractions of the radio wave absorbing material 30.

The composite member 1 may include a part where the volume fraction of the organic substance particles 20 gradually decreases from the first end which is one end of the composite member 1 toward the second end which is opposite to the first end. The composite member 1 may include, for example, a part where the volume fraction of the radio wave absorbing material 30 gradually decreases from the second end toward the first end.

The organic substance particles 20 may be uniformly dispersed throughout the composite member 1. Since the organic substance particles 20 do not easily interfere with the radio wave absorption effect of the radio wave absorbing material 30, even if they are uniformly dispersed throughout the composite member 1, the influence is small.

### [Radio wave sensor]

Next, a radio wave sensor 100 according to the present embodiment will be described. As illustrated in Fig. 4, the radio wave sensor 100 according to the present embodiment includes the composite member 1 and a sensor 110. In the present embodiment, the composite member 1 is a dielectric lens. The sensor 110 includes a substrate 120, a transmission unit 130, and a reception unit 140. The transmission unit 130 and the reception unit 140 are provided on the substrate 120. The composite member 1 is arranged to cover the transmission unit 130 and the reception unit 140. The transmission unit 130 is configured to transmit a radio wave. The reception unit 140 is configured to receive a reflected wave of the radio wave transmitted from the transmission unit 130.

The radio wave transmitted from the transmission unit 130 is an electromagnetic wave having a frequency of 3,000 GHz or less. The frequency of the radio wave may be 0.03 Hz or more and may be 3 GHz or more. The frequency of the radio wave may be 300 GHz or less. The frequency of the radio wave may be 24 GHz, 60 GHz, 76 GHz, 79 GHz, 94 GHz, or 140 GHz.

As described above, the radio wave sensor 100 according to the present embodiment includes the composite member 1, the transmission unit 130, and the reception unit 140. When a radio wave is transmitted from the transmission unit 130, the radio wave transmits through the composite member 1. The radio wave transmitted through the composite member 1 is irradiated onto an object to be irradiated and is reflected as a reflected wave from the object to be irradiated. The reflected wave is transmitted through the composite member 1 again and is received by the reception unit 140.

The composite member 1 has excellent durability compared with the case using a resin matrix and can control radio wave properties. Thus, the composite member 1 used in the radio wave sensor 100 also has excellent durability and can control properties of a radio wave transmitted from the transmission unit 130. For example, the radio wave properties of the radio wave sensor 100 can be easily adjusted by changing the radiation angle of a radio wave by adjusting the blending of the organic substance particles 20 or changing the radiation intensity of a radio wave by adjusting the blending of the radio wave absorbing material 30.

The radio wave sensor 100 may confirm the existence of an object to be irradiated and may obtain position information or speed information of the object to be irradiated. The radio wave sensor 100 may obtain information such as breathing, heartbeats, and body movements of a person, and may estimate or obtain a person's behavior or condition. The radio wave sensor 100 may be provided, for example, in a dressing room or a toilet, and may be used, for example, as a monitoring sensor or a human sensor.

### [Method for producing the composite member]

Next, a method for producing the composite member 1 according to the present embodiment will be described.

First, a method for producing the composite member 1 where the inorganic substance included in the composite member 1 is boehmite will be described. The composite member 1 where the inorganic substance is boehmite can be produced by mixing hydraulic alumina, at least one of the organic substance particles 20 or the radio wave absorbing material 30, and a solvent including water, and then heating the mixture under pressure. The hydraulic alumina is an oxide obtained through heat treatment of aluminum hydroxide and includes ρ-alumina. Such hydraulic alumina has a property of bonding and curing through a hydration reaction. Thus, by using the pressure heating method, the hydration reaction of the hydraulic alumina progresses to bond particles of the hydraulic alumina to each other, and the crystal structure changes to that of boehmite, thereby forming the composite member 1.

Specifically, a mixture is first prepared by mixing a hydraulic alumina powder, at least one of the organic substance particles 20 or the radio wave absorbing material 30, and a solvent including water. The solvent including water is preferably pure water or ion-exchanged water. The solvent including water may include an acidic substance or an alkaline substance other than water. It is sufficient that the solvent including water include water as a main component, and for example, an organic solvent (e.g., an alcohol) may be included.

Preferably, the amount of the solvent added to the hydraulic alumina is an amount sufficient to proceed the hydration reaction of the hydraulic alumina. The amount of the solvent added is, relative to the hydraulic alumina, preferably within a range of 20% to 200% by mass, and more preferably of 50% to 150% by mass.

Next, the mixture obtained by mixing the hydraulic alumina, at least one of the organic substance particles 20 or the radio wave absorbing material 30, and the solvent including water is filled inside a die. After filling the mixture in the die, the die may be heated as necessary. By applying pressure to the mixture arranged inside the die, the inside of the die enters a high pressure state. At this time, the hydraulic alumina is highly filled, and the particles of the hydraulic alumina bond with each other, resulting in high density. Specifically, by adding water to the hydraulic alumina, the hydraulic alumina undergoes a hydration reaction to form boehmite and aluminum hydroxide on the surface of the hydraulic alumina particles. By heating and pressurizing the mixture inside the die, the generated boehmite and aluminum hydroxide then diffuse mutually among the adjacent hydraulic alumina particles, and the hydraulic alumina particles gradually bond with each other. After that, the dehydration reaction proceeds by heating, and the crystalline structure is changed from aluminum hydroxide to boehmite. Note that it is supposed that the hydration reaction of the hydraulic alumina, the mutual diffusion among the hydraulic alumina particles, and the dehydration reaction proceed almost simultaneously. The composite member 1 can be obtained by taking out the molded body from the inside of the die.

Note that heating and pressurizing conditions of the mixture obtained by mixing hydraulic alumina, at least one of the organic substance particles 20 or the radio wave absorbing material 30, and a solvent including water is not particularly limited as long as the conditions are such that the reaction between the hydraulic alumina and the solvent progresses. For example, it is preferable to pressurize the mixture obtained by mixing hydraulic alumina, at least one of the organic substance particles 20 or the radio wave absorbing material 30, and a solvent including water at a pressure of 10 to 600 MPa while heating to 50 to 300 °C. Note that the temperature when the mixture obtained by mixing hydraulic alumina, at least one of the organic substance particles 20 or the radio wave absorbing material 30, and a solvent including water is heated is more preferably within a range of 80 to 250 °C and even more preferably of 100 to 200 °C. The pressure when the mixture obtained by mixing hydraulic alumina, at least one of the organic substance particles 20 or the radio wave absorbing material 30, and a solvent including water is more preferably within a range of 50 to 600 MPa and even more preferably of 200 to 600 MPa.

Next, another method for producing the composite member 1 where the inorganic substance included in the composite member 1 is boehmite will be described. The composite member 1 in which the inorganic substance is boehmite can be produced by mixing an aluminum nitride powder, at least one of the organic substance particles 20 or the radio wave absorbing material 30, and a solvent including water, and then by heating the mixture under pressure.

Specifically, an aluminum nitride powder, at least one of the organic substance particles 20 or the radio wave absorbing material 30, and a solvent including water are first mixed to prepare a mixture. The solvent including water is preferably pure water or ion-exchanged water. The solvent including water may include an acidic substance or an alkaline substance other than water. As long as the solvent includes water as its main component, for example, an organic solvent (e.g., an alcohol) may be included. In addition, the solvent including water may contain ammonia.

The amount of the solvent added to the aluminum nitride is preferably such an amount that would progress the hydrolysis reaction of the aluminum nitride described below and form aluminum hydroxide on the surface of the aluminum nitride. The amount of the solvent added to the aluminum nitride is preferably within a range of 5% to 100% by mass and more preferably of 20% to 80% by mass.

The inside of the die is then filled with the mixture obtained by mixing the aluminum nitride, at least one of the organic substance particles 20 or the radio wave absorbing material 30, and the solvent including water. After filling the die with the mixture, the die is heated as necessary. By applying pressure to the mixture arranged inside the die, the inside of the die enters a high pressure state. At this time, the aluminum nitride becomes highly packed, and aluminum nitride particles are bonded to each other to have increased density. Specifically, by pressurizing the mixture while heating, aluminum nitride and moisture react to form aluminum hydroxide on the surface of the aluminum nitride. The aluminum hydroxide formed diffuses between adjacent aluminum nitride particles, and aluminum nitride particles are gradually connected to each other. Then, the dehydration reaction progresses due to heating, and the crystal structure changes from aluminum hydroxide to boehmite. Consequently, adjacent aluminum nitride particles are bonded via the boehmite phase including boehmite. Then, the composite member 1 can be obtained by taking out the molded body from the inside of the die.

Note that heating and pressurizing conditions of the mixture obtained by mixing aluminum nitride and a solvent including water are not particularly limited as long as the conditions are such that the reaction between aluminum nitride and the solvent and the dehydration reaction of the aluminum hydroxide progress. For example, it is preferable to pressurize the mixture at a pressure of 10 to 600 MPa while heating the mixture to 50 to 300 °C. Note that the temperature at which the mixture is heated is more preferably within a range of 80 °C to 250 °C and more preferably of 100 °C to 200 °C. The pressure at which the mixture is pressurized is more preferably within a range of 50MPa or more and 600 MPa or less and more preferably of 200 MPa or more and 600 MPa or less.

Next, a method for producing the composite member 1 wherein the inorganic substance included in the matrix part 10 is a metal oxide will be described. First, a solvent is added to a mixed powder including a powder of the inorganic substance and at least one of the organic substance particles 20 or the radio wave absorbing material 30. The solvent is not particularly limited, but, for example, a solvent capable of dissolving part of the inorganic substance when the mixed powder is pressurized and heated can be used. As the solvent, it is possible to use a solvent capable of reacting with the inorganic substance to form another inorganic substance different from said inorganic substance. As such a solvent, at least one selected from the group consisting of an acidic aqueous solution, an alkaline aqueous solution, water, an alcohol, a ketone, and an ester can be used. As the acidic aqueous solution, an aqueous solution having a pH of 1 to 3 can be used. As the alkaline aqueous solution, an aqueous solution having a pH of 10 to 14 can be used. As the acidic aqueous solution, an aqueous solution of an organic acid is preferably used. As the alcohol, an alcohol with 1 to 12 carbon atoms is preferably used.

The inside of the die is then filled with the mixture including the mixed powder and solvent. After filling the die with the mixture, the die may be heated as necessary. By applying pressure to the mixture arranged inside the die, the inside of the die enters a high pressure state. At this time, the inorganic substance in the mixture is densified, and the particles of the inorganic substance are bonded to each other.

Here, when a solvent that dissolves part of the inorganic substance is used, an inorganic compound included in the inorganic substance is dissolved in the solvent under a high pressure state. The dissolved inorganic compound penetrates into voids in the inorganic substance. Then, the solvent in the mixture is removed in this state to form the bonding part 12 derived from the inorganic substance in the inorganic substance. When a solvent that reacts with an inorganic substance to generate another inorganic substance different from said inorganic substance is used as the solvent, an inorganic compound included in the inorganic substance reacts with the solvent under a high pressure state. Then, the other inorganic substance generated through the reaction is filled in voids in the inorganic substance to form the bonding part 12 derived from the other inorganic substance.

Heating and pressurizing conditions of a mixture including the inorganic substance and the solvent are not particularly limited as long as the conditions are such that when a solvent that dissolves part of the inorganic substance is used, the dissolution of the surface of the inorganic substance progresses. Heating and pressurizing conditions of the mixture are not particularly limited as long as the conditions are such that when a solvent is used that reacts with an inorganic substance to generate another inorganic substance different from said inorganic substance, the reaction between the inorganic substance and the solvent progresses. For example, it is preferable to heat the mixture including the inorganic substance and the solvent to 50 to 300 °C and then to pressurize at a pressure of 10 to 600 MPa. Note that the temperature at which the mixture including the inorganic substance and the solvent is heated is more preferably within a range of 80 °C to 250 °C, and even more preferably of 100 °C to 200 °C. The pressure at which the mixture including the inorganic substance and the solvent is pressurized is more preferably within a range of 50 Mpa to 400 MPa, and even more preferably of 50 MPa to 200 MPa. Then, the composite member 1 can be obtained by taking out the molded body from the inside of the die.

Here, a sintering method has been known as a method for producing an inorganic member including ceramic. The sintering method is a method for obtaining a sintered body by heating an aggregate of a solid powder containing an inorganic substance at a temperature lower than the melting point. However, in the sintering method, the solid powder is heated to 1,000 °C or higher, for example. Thus, when the sintering method is used to obtain the composite member 1 including an organic substance having low heat resistance, the organic substance is carbonized due to heating at a high temperature. However, in the method for producing the composite member 1 according to the present embodiment, the carbonization of the organic substance is unlikely to occur due to heating at a low temperature of 300 °C or less.

Further, in the producing method according to the present embodiment, the inorganic substance powder is pressurized while being heated, and thus the inorganic substance aggregates to form the composite member 1, which is dense. Consequently, the number of pores inside the composite member 1 decreases, and thus the composite member 1 can be obtained having high strength.

As described above, the method for producing the composite member 1 includes a step of obtaining a mixture by mixing hydraulic alumina, at least one of organic substance particles 20 or the radio wave absorbing material 30, and a solvent including water, and a step of pressurizing and heating the mixture. The pressure heating condition of the mixture is preferably a temperature of 50 to 300 °C and a pressure of 10 to 600 MPa. In the producing method, since the composite member 1 is molded under a low temperature condition, the composite member 1 obtained is mainly made from a boehmite phase. Thus, the composite member 1 can be obtained which is lightweight and excellent in chemical stability, using a simple method.

The method for producing the composite member 1 according to another embodiment includes a step of mixing aluminum nitride particles, at least one of organic substance particles 20 or the radio wave absorbing material 30, and a solvent including water to obtain a mixture, and a step of pressurizing and heating the mixture. The heating and pressurizing condition of the mixture is preferably a temperature of 50 to 300 °C and a pressure of 10 to 600 MPa. Since the heating temperature of the producing method according to the present embodiment is low, aluminum nitride is bonded via a boehmite phase in the obtained composite member 1. Thus, it becomes possible to obtain the composite member 1 having excellent mechanical strength and excellent chemical stability using a simple method.

The method for producing the composite member 1 according to another embodiment includes a step of mixing a solvent for dissolving an inorganic substance or a solvent reacting with the inorganic substance, a powder of the inorganic substance, and at least one of organic substance particles 20 or the radio wave absorbing material 30 to obtain a mixture. The method includes a step of pressurizing and heating the mixture. The heating and pressurizing condition of the mixture is preferably a temperature of 50 to 300 °C and a pressure of 10 to 600 MPa. In the producing method according to the present embodiment, since the composite member 1 is molded under such a low temperature condition, changes in physical or chemical properties due to heat can be suppressed. Thus, the composite member 1 applicable to various uses can be obtained.

### EXAMPLES

The present embodiment will be described in more detail below with examples and comparative examples, but the present embodiment is not limited thereto.

First, the relationship between the relative permittivity and the radiation angle for ABS, glass, and aluminum oxide (Al₂O₃) was analyzed through simulation. Note that, for the ABS, the relative permittivity (εᵣ) was set to 2.61 and the dielectric tangent (tanδ) was set to 0.007. For the glass, the relative permittivity was set to 5.5 and the dielectric tangent was set to 0.007. For the aluminum oxide, the relative permittivity was set to 9.8 and the dielectric tangent was set to 0.007. For the relative permittivity and the dielectric tangent, values at a temperature of 25 °C and a frequency of 1 MHz were adapted.

### (Radiation angle)

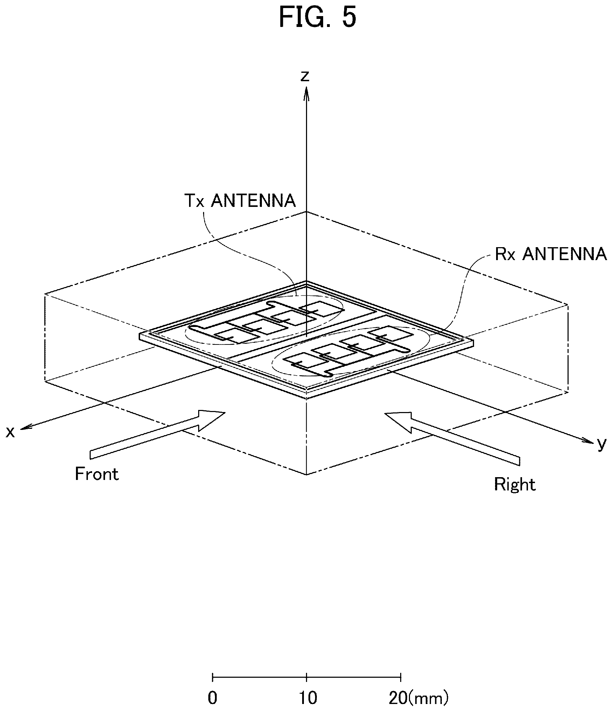

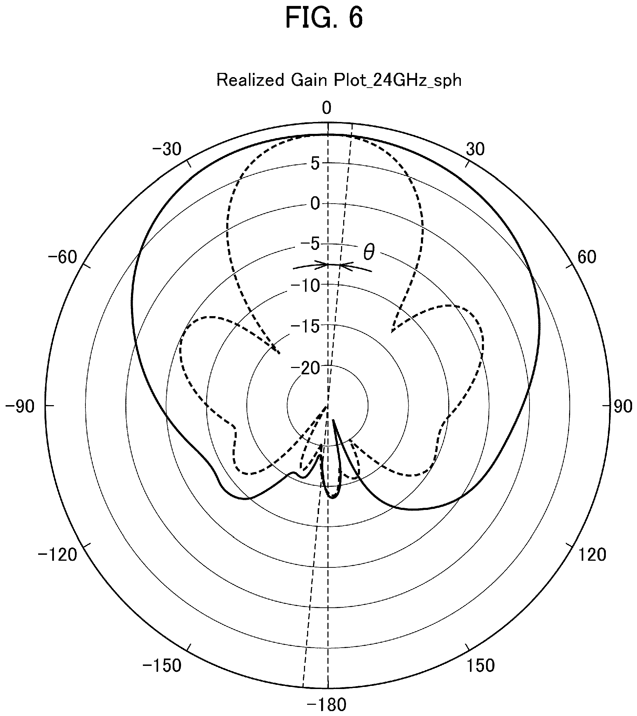

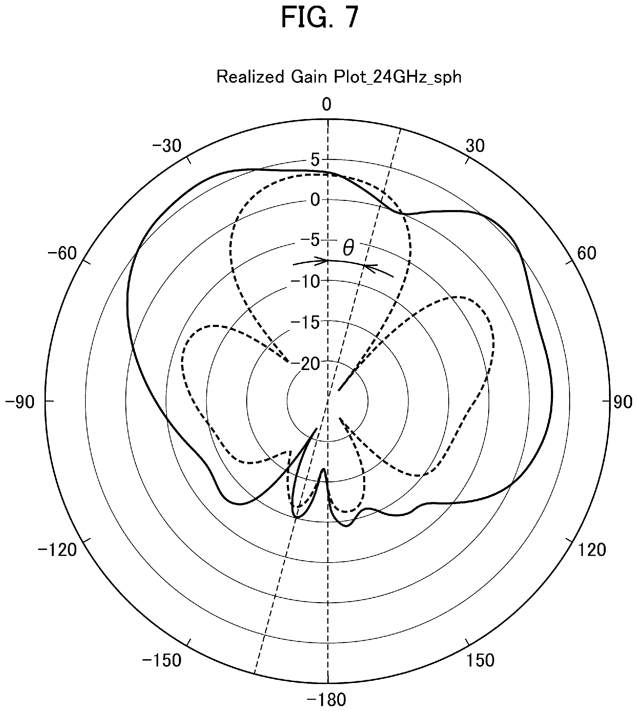

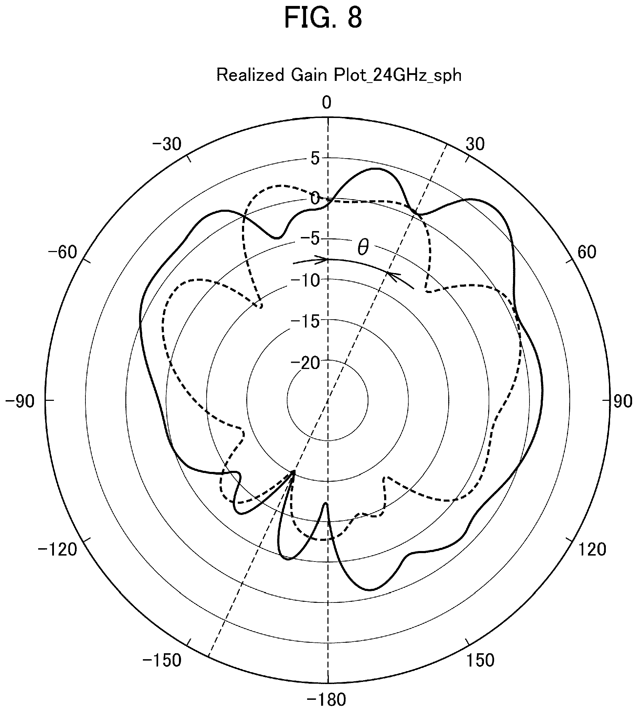

First, the radiation pattern was analyzed using a high-frequency three-dimensional electromagnetic field analysis software Ansys (registered trademark) HFSS. In the analysis, as illustrated in Fig. 5, a sensor was used which included a Tx antenna with four elements arranged in the X direction and an Rx antenna with four elements arranged in the X direction and in which the Tx antenna and the Rx antenna were arranged in the Y direction. The sensor was covered with a plate of ABS, glass, or aluminum oxide (Al₂O₃). The radiation pattern was analyzed from a realized gain obtained when 1 W power was supplied to the feed line of the Tx antenna at a lumped port with a frequency of 24.15 GHz, a max DeltaS of 0.001%, and an analysis time of 15 times. In the vertical polarization in the YZ plane illustrated with the solid lines in Figs. 6 to 8, among the maximum points, an angle that is half the sum of the maximum output angle and the second highest output angle was set as the radiation angle (θ). However, in Fig. 6, since the second maximum point does not exist in the front (+90 degrees to -90 degrees), the maximum output angle was set as the radiation angle. Note that it has been confirmed that the radiation pattern obtained from the simulation analysis and the radiation pattern obtained in the actual measurement have almost the same result.

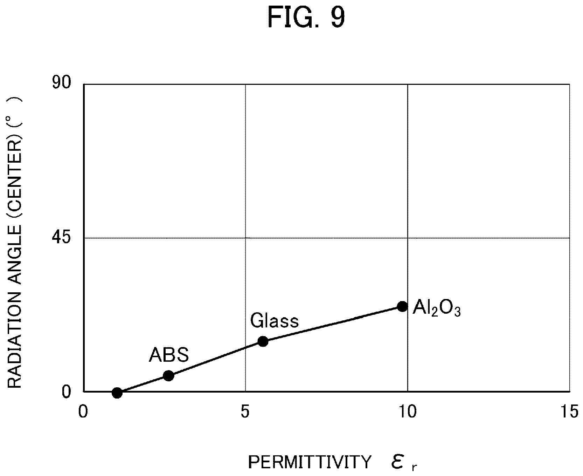

Figs. 6 to 8 illustrate the radiation patterns of ABS, glass, and aluminum oxide, respectively. θ in the figures indicates the radiation angle. Fig. 9 is a graph illustrating the relationship between the relative permittivity and the radiation angle. As illustrated in Figs. 6 to 9, the larger the value of the relative permittivity, the larger the value of the radiation angle, and it was confirmed that the relative permittivity and the radiation angle were related to each other.

Next, the following test samples were produced, and the relative permittivity of each test sample was measured.

### [Sample 1]

First, hydraulic alumina BK-112 manufactured by SUMITOMO CHEMICAL COMPANY, LIMITED having a median particle size of 16 µm was prepared as the inorganic substance. Polytetrafluoroethylene particles (PTFE fine powder KTL-1N manufactured by Taki Chemical Co., Ltd.) were prepared as the organic substance particles. After the PTFE was weighted to be 40% by volume relative to the sum of the hydraulic alumina and PTFE, the hydraulic alumina and PTFE were mixed using an agate mortar and pestle to obtain a mixed powder. Next, the ion-exchanged water was weighed to be 80% by mass relative to the hydraulic alumina, and then the mixed powder and ion-exchanged water were mixed using an agate mortar and pestle to obtain a mixture. Next, the obtained mixture was filled inside a cylindrical molding die (Φ12) having an internal space. The test sample was produced by heating and pressurizing the mixture arranged inside the die under conditions of 400 MPa, 180 °C, and 20 minutes.

### [Sample 2]

A test sample was produced in the same manner as sample 1 except that the test sample was prepared without adding PTFE.

### [Sample 3]

First, an aluminum nitride powder (purity: 3N) manufactured by Kojundo Chemical Lab. Co., Ltd. was prepared as the inorganic substance. Polytetrafluoroethylene particles (PTFE fine powder KTL-1N manufactured by Taki Chemical Co., Ltd.) were prepared as the organic substance particles. After the PTFE was weighted to be 40% by volume relative to the sum of the aluminum nitride and PTFE, the aluminum nitride and PTFE were mixed using an agate mortar and pestle to obtain a mixed powder. Next, the ion-exchanged water was weighed to be 80% by mass relative to the aluminum nitride, and then the mixed powder and ion-exchanged water were mixed using an agate mortar and pestle to obtain a mixture. Next, the obtained mixture was filled inside a cylindrical molding die (Φ12) having an internal space. The test sample was produced by heating and pressurizing the mixture arranged inside the die under conditions of 400 MPa, 180 °C, and 20 minutes.

### [Sample 4]

A test sample was produced in the same manner as sample 3 except that the test sample was prepared without adding PTFE.

Next, the following plate-like materials were obtained, and the relative permittivity was measured as a reference.

### [Reference example 1]

Al₂O₃ (purity 99.97%)

### [Reference example 2]

ABS

### [Reference example 3]

PMMA (acrylic)

### [Reference example 4]

### PTFE

### (Relative permittivity)

For each test sample and plate-like material, the relative permittivity was measured using an impedance/material analyzer (Agilent E4991A RF) manufactured by Agilent Technologies Japan, Ltd. The measurement temperature was set to 25 °C, and the measurement frequency was set to 1 GHz.

**[Table 1]**

| | Matrix part | Organic substance particles | Relative permittivity |
|---|---|---|---|
| Sample 1 | Boehmite | PTFE40vol% | 8.4 |
| Sample 2 | Boehmite | - | 14.9 |
| Sample 3 | AIN | PTFE40vol% | 4.8 |
| Sample 4 | AIN | - | 7.3 |
| Reference example 1 | Al₂O₃ (commercially available board material) | - | 11.4 |
| Reference example 2 | ABS (commercially available board material) | - | 2.8 |
| Reference example 3 | PMMA (commercially available board material) | - | 2.8 |
| Reference example 4 | PTFE (commercially available board material) | - | 2.1 |

From the comparison of sample 1 with sample 2, it was possible to reduce the relative permittivity value by adding PTFE to boehmite. From the comparison of sample 3 with sample 4, it was possible to reduce the relative permittivity value by adding PTFE to aluminum nitride.

From these results, it is though possible to obtain a composite member having a small relative permittivity even when PTFE is added to a matrix part containing at least one of a metal oxide or a metal oxide hydroxide. Similarly, when organic substance particles such as ABS or PMMA are added to boehmite or aluminum nitride, a composite member having a small relative permittivity can also be obtained. That is, by adjusting the type and amount of organic substance particles added to the inorganic substance particles, it is thought possible to adjust the relative permittivity of the obtained composite member.

Next, the radiation pattern was measured for sample 1 and sample 2, and the radiation angle was obtained. Specifically, an SMR333 manufactured by InnoSenT GmbH was covered with sample 1 or 2, and the radiation patterns in the XZ and YZ planes were produced from the EIRP (equivalent isotropic radiated power) obtained when the transmission power was set to 4dBm (Typical) and the frequency was set to 24.15 GHz. For the parallel polarization (XZ-plane, Hori.) in the radiation pattern in the XZ plane and the vertical polarization (YZ-plane, Vert.) in the radiation pattern in the YZ plane, an angle at which the EIRP was 10dB smaller than the maximum value was measured as -10dB angle.

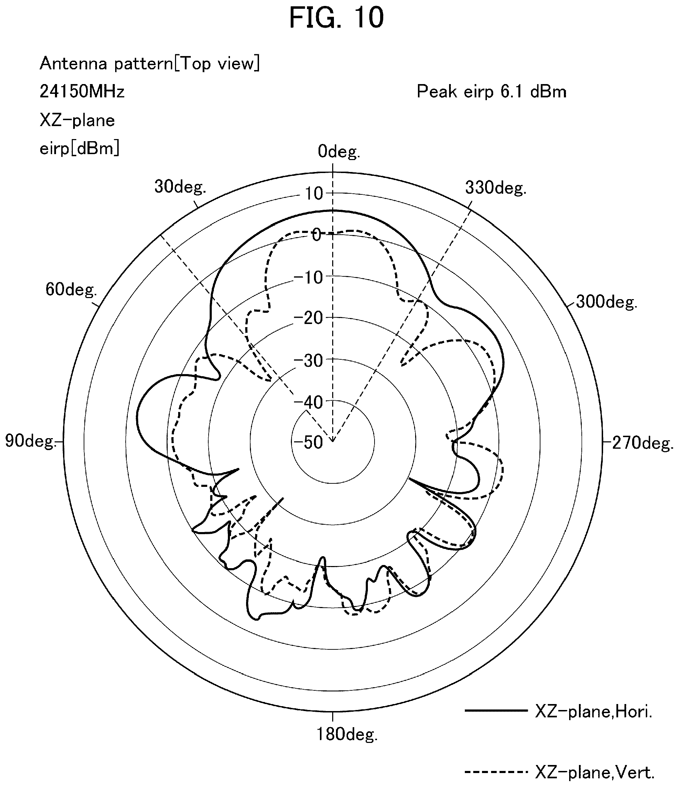

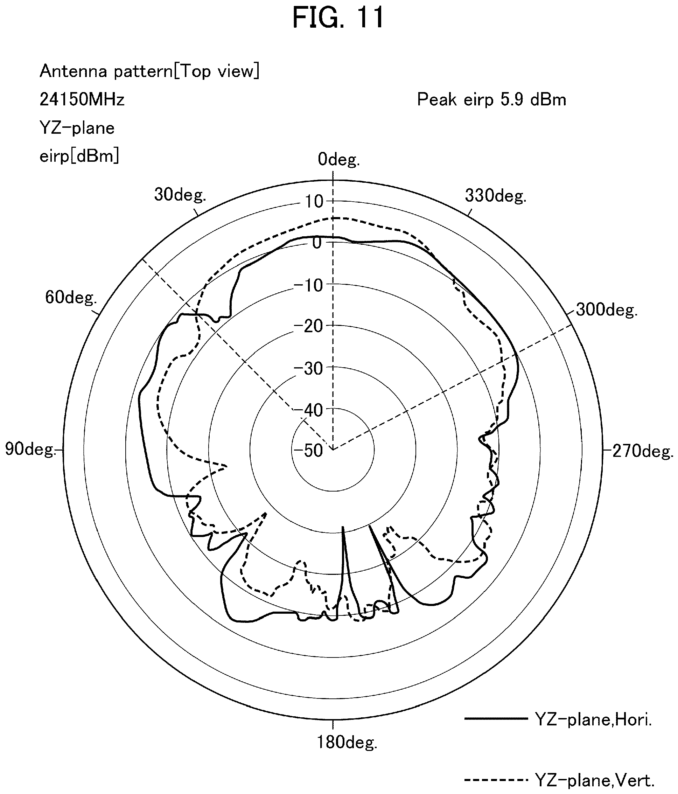

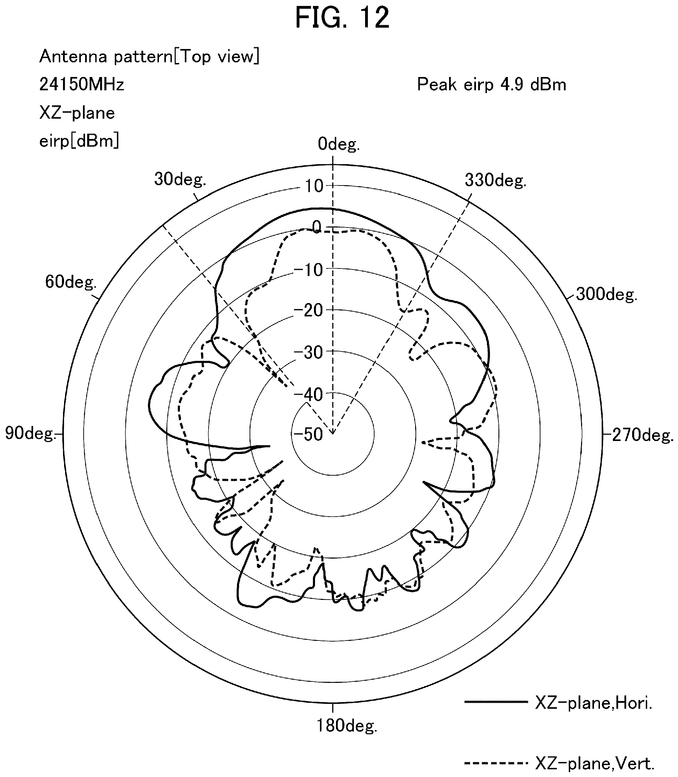

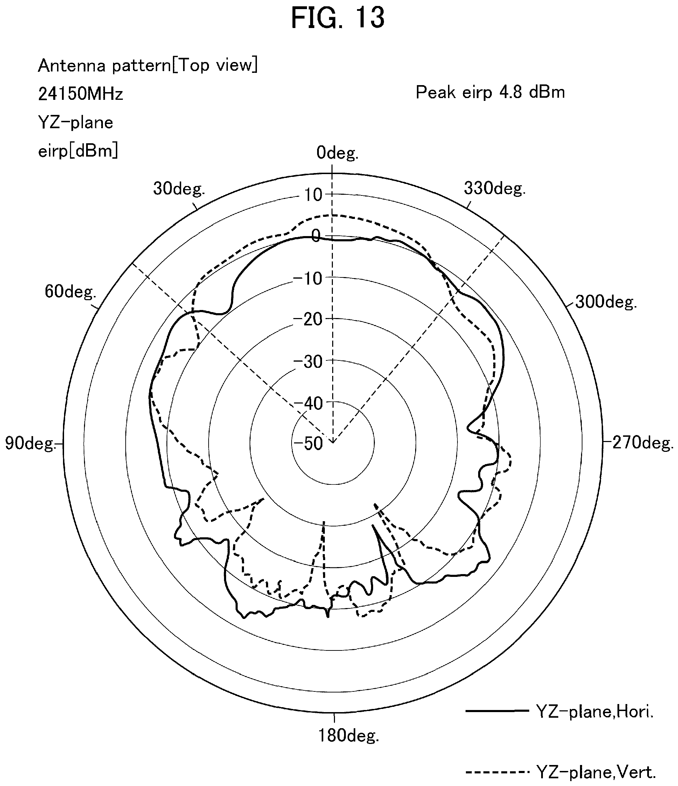

The radiation pattern in the XZ plane measured for sample 1 is illustrated in Fig. 10 as pattern 1. The radiation pattern in the YZ plane measured for sample 1 is illustrated in Fig. 11 as pattern 2. The radiation pattern in the XZ plane measured for sample 2 is illustrated in Fig. 12 as pattern 3. The radiation pattern in the YZ plane measured for sample 2 is illustrated in Fig. 13 as pattern 4. The relationship between each sample and the -10dB angle is illustrated in Table 2.

**[Table 2]**

| Pattern No. | Sample No. | Matrix part | Organic substance particles | Measure ment plane | Polarization | -10dB degree (deg.) |
|---|---|---|---|---|---|---|
| Pattern 1 | Sample 1 | Boehmite | PTFE 40vol% | XZ plane | Parallel | 80 |
| Pattern 2 | Sample 1 | Boehmite | PTFE 40vol% | YZ plane | Vertical | 105 |
| Pattern 3 | Sample 2 | Boehmite | - | XZ plane | Parallel | 70 |
| Pattern 4 | Sample 2 | Boehmite | - | YZ plane | Vertical | 85 |

From the comparison of pattern 1 with pattern 3 and the comparison of pattern 2 with pattern 4, it was confirmed that the -10dB angle was larger in sample 1 than in sample 2. From this, it was found that the radiation angle could be controlled by adding organic substance particles to the matrix part of the inorganic substance and changing the relative permittivity, similar to the simulation results.

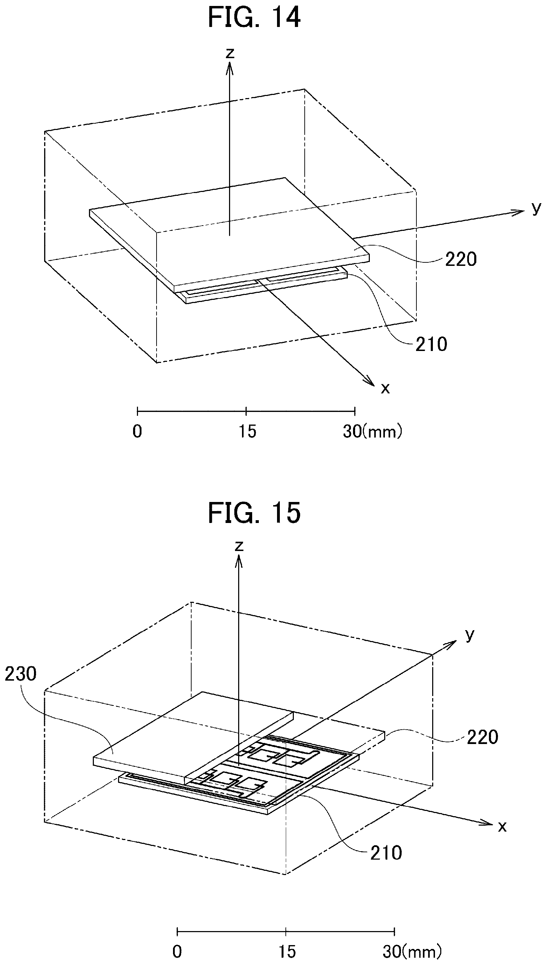

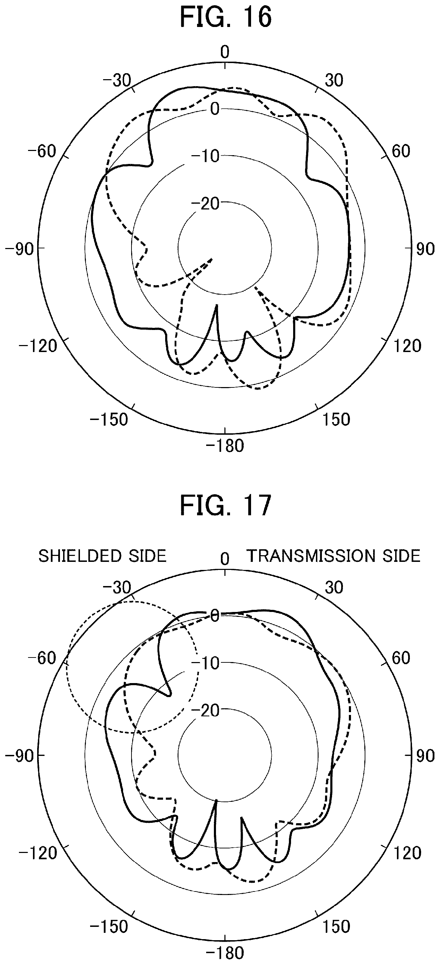

Next, the shielding effect of the radio wave using the radio wave absorbing material was evaluated. Specifically, as illustrated in Fig. 14, the radiation pattern when a sensor 210 is covered with a plate 220 made from boehmite was analyzed using simulation in the same manner as above. As illustrated in Fig. 15, the radiation pattern when the sensor 210 is covered half by half with the plate 220 made from boehmite and a shield plate 230 made from carbon was analyzed using simulation in the same manner as described above. The radiation pattern when the sensor is not covered by the shield plate is illustrated in Fig. 16. The radiation pattern when half of the sensor is covered by the shield plate is illustrated in Fig. 17.

As circled in Fig. 17, it is evident that the radiation of radio waves is suppressed in the part where the sensor is shielded by the shield plate. From this result, it was confirmed that partial shielding of radio waves can be achieved using the radio wave absorbing material in the desired area.

Next, a composite member including a radio wave shield part and a radio wave transmission part was produced.

First, hydraulic alumina BK-112 manufactured by SUMITOMO CHEMICAL COMPANY, LIMITED having a median particle size of 16 µm was prepared as the inorganic substance. Polytetrafluoroethylene particles (PTFE fine powder KTL-1N manufactured by Taki Chemical Co., Ltd.) were prepared as the organic substance particles. After the PTFE was weighted to be 30% by volume relative to the hydraulic alumina, the hydraulic alumina and PTFE were mixed using an agate mortar and pestle to obtain a mixed powder. Next, the ion-exchanged water was weighed to be 80% by mass relative to the hydraulic alumina, and then the mixed powder and ion-exchanged water were mixed using an agate mortar and pestle to obtain a mixture 1.

A graphite powder manufactured by Wako Pure Chemical Corporation was prepared as the radio wave absorbing material. After the graphite was weighed to be 30% by volume relative to the above hydraulic alumina, the hydraulic alumina and graphite were mixed using an agate mortar and pestle to obtain a mixed powder. Next, the ion-exchanged water was weighed to be 80% by mass relative to the hydraulic alumina, and then the mixed powder and ion-exchanged water were mixed using an agate mortar and pestle to obtain a mixture 2.

Next, the mixture 1 and the mixture 2 were filled inside a cylindrical molding die (Φ50) having an internal space almost equally on the right and left sides. The test sample was produced by heating and pressurizing the mixture arranged inside the die under conditions of 400 MPa, 180 °C, and 20 minutes.

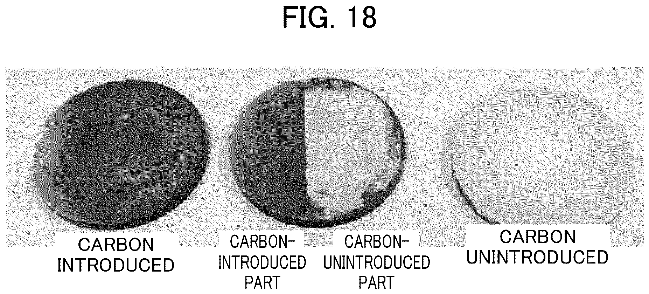

The composite member obtained using the above method is illustrated in the center of Fig. 18. With the above method, as illustrated in the center of Fig. 18, it was possible to obtain a composite member including a carbon-introduced part (shield part) in which carbon (graphite) was introduced and an unintroduced part (transmission part) in which carbon was not introduced. Note that a composite member without carbon introduction produced for the mixture 1 is illustrated on the right side of Fig. 18, and a composite member with carbon introduction produced for the mixture 2 is illustrated on the left side of Fig. 18.

Next, samples 5 and 6 were produced, and their porosities were measured.

### [Sample 5]

First, hydraulic alumina BK-112 manufactured by SUMITOMO CHEMICAL COMPANY, LIMITED having a median particle size of 16 µm was prepared as the inorganic substance. Polytetrafluoroethylene particles (PTFE fine powder KTL-1N manufactured by Taki Chemical Co., Ltd.) were prepared as the organic substance particles. The hydraulic alumina and PTFE were weighted in such a manner that the PTFE was 40% by volume relative to the total of the hydraulic alumina and PTFE, and then mixed using an agate mortar and pestle to obtain a mixed powder. Next, the ion-exchanged water was weighed to be 80% by mass relative to the hydraulic alumina, and then the mixed powder and ion-exchanged water were mixed using an agate mortar and pestle to obtain a mixture. Next, the obtained mixture was filled inside a cylindrical molding die (Φ12) having an internal space. The test sample was produced by heating and pressurizing the mixture arranged inside the die under conditions of 400 MPa, 180 °C, and 20 minutes.

### [Sample 6]

First, hydraulic alumina BK-112 manufactured by SUMITOMO CHEMICAL COMPANY, LIMITED having a median particle size of 16 µm was prepared as the inorganic substance. A graphite powder manufactured by Wako Pure Chemical Corporation was prepared as the radio wave absorbing material. The hydraulic alumina and graphite were weighed in such a manner that the graphite was 40% by volume relative to the sum of the hydraulic alumina and graphite, and then mixed using an agate mortar and pestle to obtain a mixed powder. Next, the ion-exchanged water was weighed to be 80% by mass relative to the hydraulic alumina, and then the mixed powder and ion-exchanged water were mixed using an agate mortar and pestle to obtain a mixture. Next, the obtained mixture was filled inside a cylindrical mold (Φ12) having an internal space. The test sample was then produced by heating and pressurizing the mixture arranged inside the die under conditions of 400 MPa, 180 °C, and 20 minutes.

### (Porosity measurement)

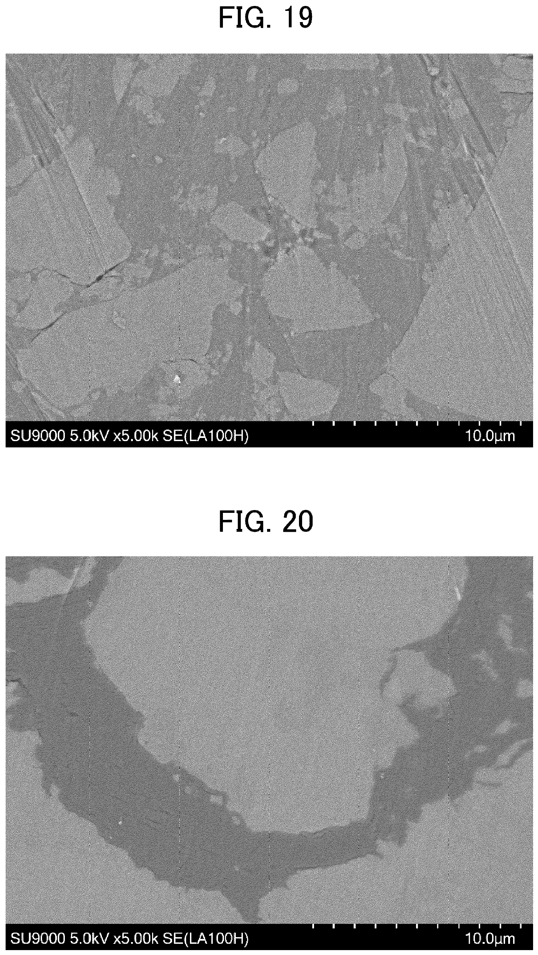

First, cross section polisher processing (CP processing) was applied to the cross section of the cylindrical sample. Next, a scanning electron microscope (SEM) was used to observe the backscattered electron image at a magnification of 5,000 times on the cross section of the sample. The backscattered electron images obtained by observing the cross sections of sample 5 and sample 6 are illustrated in Figs. 19 and 20, respectively.

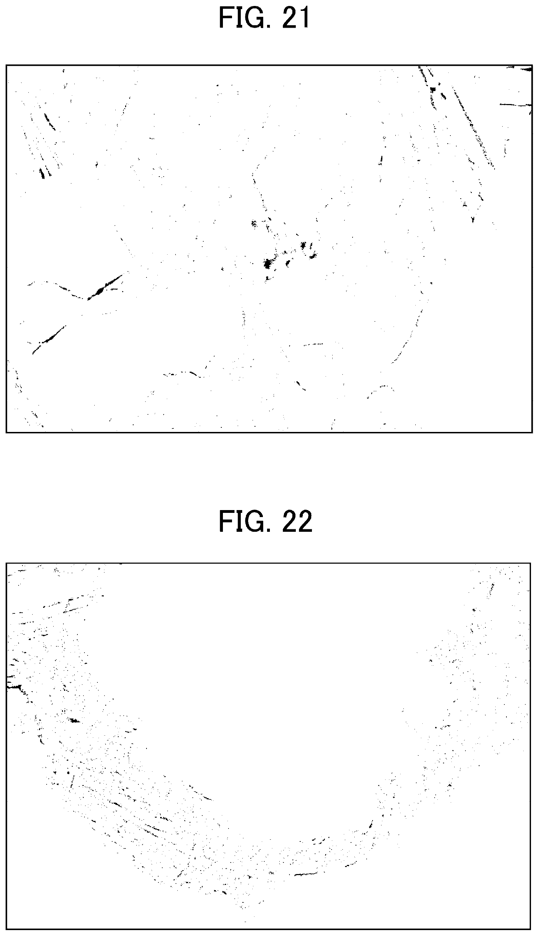

Then, pore parts were clarified by binarizing the obtained SEM images, respectively. Fig. 21 illustrates an image obtained by binarizing the backscattered electron image of Fig. 19. Fig. 22 illustrates an image obtained by binarizing the backscattered electron image of Fig. 20. In Figs. 21 and 22, the black part indicates pores. The area percentage of the pore parts was calculated from the binarized images, and the average value was taken as the porosity. From Fig. 21, the porosity of sample 5 was 0.57%. From Fig. 22, the porosity of sample 6 was 0.50%. From the porosity measurement results, it was found that the porosity of these composite members was small. Since the porosity of the composite members is small, it is thought that the occurrence of cracks in the composite members originating from pores is suppressed.

The entire contents of Japanese Patent Application No. 2021-208048 (filed December 22, 2021) are incorporated herein by reference.

Although the present embodiment has been described above, the present embodiment is not limited to these descriptions, and various modifications are possible within the scope of the gist of the present embodiment.

### INDUSTRIAL APPLICABILITY

The present disclosure provides a composite member that has excellent durability compared with using a resin matrix and is capable of controlling radio wave properties.

### REFERENCE SIGNS LIST

- 1: Composite member
- 10: Matrix part
- 11: Inorganic substance particles
- 20: Organic substance particles
- 30: Radio wave absorbing material

## Claims

1. A composite member, comprising:
a matrix part that includes inorganic substance particles and is formed by bonding the inorganic substance particles to each other;
organic substance particles present in a dispersed state inside the matrix part; and
a radio wave absorbing material present in a dispersed state inside the matrix part, wherein
the matrix part includes at least one of a metal oxide or a metal oxide hydroxide.

2. The composite member according to claim 1, wherein a porosity in a cross section is 20% or less.

3. The composite member according to claim 1 or 2, wherein the organic substance particles and the radio wave absorbing material are not present continuously from the surface to the inside of the matrix part.

4. The composite member according to any one of claims 1 to 3, wherein the volume fraction of the organic substance particles is less than 50%.

5. The composite member according to any one of claims 1 to 4, wherein the radio wave absorbing material includes carbon and is partially present.

6. The composite member according to any one of claims 1 to 5, wherein a thermal conductivity of the matrix part is higher than that of the organic substance particles.
